Europäisches Patentamt

European Patent Office

Office européen des brevets

(19)

(11) **EP 0 393 526 B2**

(12) **NEUE EUROPÄISCHE PATENTSCHRIFT**

(45) Veröffentlichungstag und Bekanntmachung des Hinweises auf die Entscheidung über den Einspruch:
**27.08.2003   Patentblatt 2003/35**

(45) Hinweis auf die Patenterteilung:
**17.07.1996   Patentblatt 1996/29**

(21) Anmeldenummer: **90107082.1**

(22) Anmeldetag: **12.04.1990**

(51) Int Cl.⁷: **H03M 7/30**, H03M 7/42

(54) **Digitales Codierverfahren**

Digital encoding method

Procédé de codage numérique

(84) Benannte Vertragsstaaten:
**AT BE CH DE DK ES FR GB GR IT LI LU NL SE**

(30) Priorität: **17.04.1989   DE 3912605**

(43) Veröffentlichungstag der Anmeldung:
**24.10.1990   Patentblatt 1990/43**

(60) Teilanmeldung:
**94106503.9 / 0 612 156**

(73) Patentinhaber: **FRAUNHOFER-GESELLSCHAFT ZUR FÖRDERUNG DER ANGEWANDTEN FORSCHUNG E.V.**
**80636 München (DE)**

(72) Erfinder:
• **Grill, Bernhard**
  **D-8540 Rednitzhembach (DE)**
• **Kürten, Bernd**
  **D-8521 Grossenseebach (DE)**
• **Eberlein, Ernst**
  **D-8521 Grossenseebach (DE)**
• **Sporer, Thomas**
  **D-8511 Fürth (DE)**
• **Brandenburg, Karl-Heinz**
  **D-8520 Erlangen (DE)**

(74) Vertreter: **Schoppe, Fritz, Dipl.-Ing. et al Patentanwälte Schoppe, Zimmermann, Stöckeler & Zinkler,**
**Postfach 246**
**82043 Pullach bei München (DE)**

(56) Entgegenhaltungen:
EP-A- 0 166 607          WO-A-88/01811
WO-A-88/04117          US-A- 3 675 211
US-A- 3 717 851          US-A- 4 475 174
US-A- 4 813 056          US-A- 4 816 914

• **Markel/Gray: "Linear Prediction of Speech", Seiten 246. 247**
• **AES, 82nd Convention, London Theile et al.: "Low-bit rate coding of high quality audio signals", Seiten 1-31**
• **JAY: "Digital coding of waveforms", Seiten 146, 147, 486, 487**
• **J. D. Markel, A. H. Gray, 'linear prediction of speech', Springer Verlag 1976, Seiten 246, 247**
• **G. Theile et al. 'low bit rate encoding of high quality audio signals', Aes preprint 2432 (c-1), AES convention, London, March 10-13, 1987, Figur 8 und Abschnitt 2.4**
• **N. S. Jayant, P. Noll, 'Digital coding of waveforms', Prentice Hall, 1984, Seiten 146, 147**
• **XP 000646433: F. Itakura and S. Saito, ' Analysis syntesis telephony based on the maximum likelihood method', The 6th International Congress on Acoustics, Tokyo, Japan, August 21-28, 1968, C-5-5, Seiten C-17 bis C-20**

Bemerkungen:
Teilanmeldung 94106503.9 eingereicht am 12/04/90.

**Beschreibung**

Die Erfindung bezieht sich auf ein digitales Codierverfahren für die Übertragung und/oder Speicherung von akkustischen Signalen und insbesondere von Musiksignalen gemäß dem Oberbegriff des Patentanspruchs 1.

Verfahren gemäß dem Oberbegriff des Patentanspruchs 1 sind beispielsweise aus der DE-PS 33 10 480 oder aus der WO 88/ 01811 bekannt. Auf die genannten Druckschriften wird im übrigen zur Erläuterung aller hier nicht näher beschriebenen Begriffe ausdrücklich Bezug genommen.

Insbesondere bezieht sich die Erfindung auf das in der WO 88/01811 erstmals vorgeschlagene OCF-Verfahren.

Erfindungsgemäß werden entweder für die Berechnung der "erlaubten Störung" eines Datenblockes längere Signalabschnitte verwendet als in einem Block codiert werden, oder die Berechnungsvorschrift ist von den Ergebnissen vorheriger Zeitabschnitte abhängig.

Die Erfindung wird nachstehend anhand der Zeichnung näher beschrieben, in der zeigen:

Fig. 1    ein Spektrum mit ausgeprägtem Maximum,
Fig. 2    Codewörter in einem festen Raster,

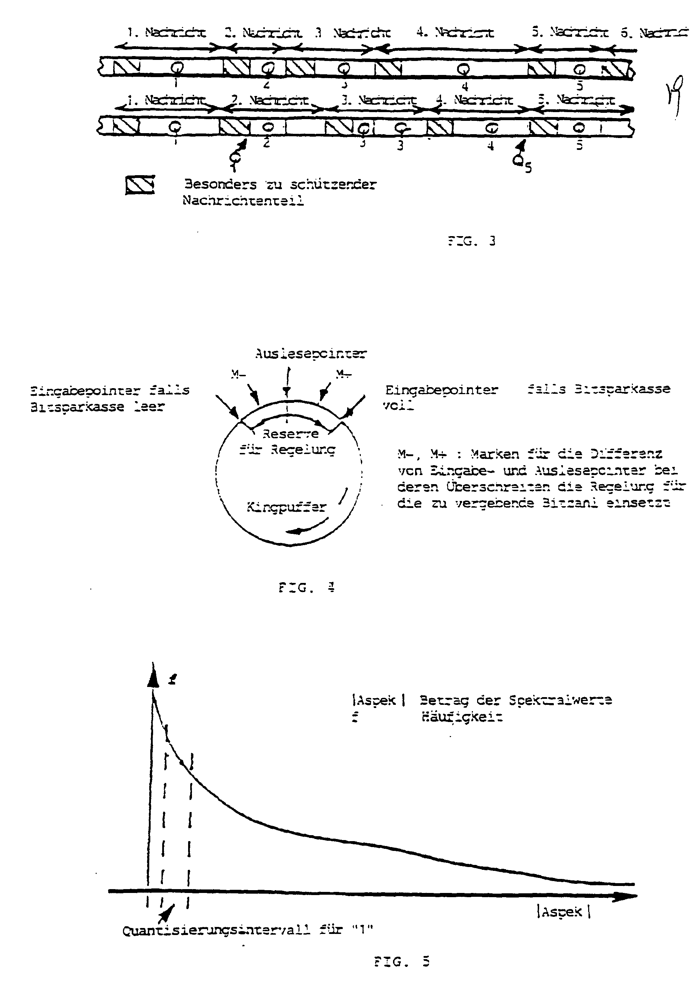

Fig. 3    die Anordnung wichtiger Nachrichtenteile in einem festen Raster,
Fig. 4    schematisch den als "Bitsparkasse" dienenden Ringpuffer, und
Fig. 5    die Häufigkeitsverteilung des Spektrums.

Bei digitalen Codierverfahren für die Übertragung und/oder Speicherung von akustischen Signalen und insbesondere von Musiksignalen wird im allgemeinen so vorgegangen, daß zunächst die Abtastwerte des akustischen Signals in eine Folge von zweiten Abtastwerten transformiert werden, die die spektrale Zusammensetzung des akustischen Signals wiedergeben. Diese Folge von zweiten Abtastwerten wird dann entsprechend den Anforderungen mit unterschiedlicher Genauigkeit quantisiert und teilweise oder ganz mittels eines Optimalcodierers codiert. Bei der Wiedergabe erfolgt eine entsprechende Decodierung und Rücktransformation.

Die Umsetzung der Abtastwerte des akustischen Signals in eine Folge zweiter Abtastwerte kann dabei mittels einer Transformation oder einer Filterbank erfolgen, wobei gegebenenfalls das Ausgangssignal der Filterbank "unter"abgetastet wird, so daß eine Blockbildung wie bei einer Transformation entsteht.

Bei einem bevorzugten Ausführungsbeispiel wird in an sich bekannter Weise ein Codierer, d.h. eine Codezuordnung verwendet, bei der die Auftrittswahrscheinlichkeit des quantisierten Spektralkoeffizienten mit der Länge des Codes derart korreliert ist, daß das Codewort um so kürzer ist, je häufiger der Spektralkoeffizient auftritt (Anspruch 5). Derartige Codierer sind beispielsweise unter der Bezeichnung Huffmancodes bekannt (Anspruch 7).

Ferner werden erfindungsgemäß zur Reduzierung der Tabellengröße des Codierers entweder mehreren Elementen der Folge oder einem Wertebereich ein Codewort sowie gegebenenfalls ein Zusatzcode zugeordnet.

Die gemeinsame Codierung von Spektralkoeffizienten kann dabei auf verschiedene Arten erfolgen: Beispielsweise kann sie im Frequenzraum oder in der Zeitachse vorgenommen werden, wobei dieselben Koeffizienten aus aufeinanderfolgenden Blöcken gemeinsam codiert werden (Anspruch 10). Ferner kann einem Wertebereich in einer Art Grobquantisierung ein Codewort zugeordnet werden. Auch ist eine direkte Codierung eines Teilbereichs möglich, wobei der Rest des Wertebereichs mit einer gesonderten Kennung versehen und zusätzlich der Offset zur Wertebereichsgrenze codiert wird (Anspruch 6).

Der Code wird dabei im allgemeinen einer Tabelle entnommen, deren Länge der Anzahl der Codewörter entspricht. Falls eine große Anzahl von Codewörtern mit einer Wortlänge, die größer als die durchschnittliche Wortlänge ist, eine ähnliche Wortlänge besitzt, können alle diese Codewörter mit einem geringen Verlust an Codiereffektivität durch eine gemeinsame Kennung und einen nachfolgenden besonderen Code, der dem Anwendungsfall angepaßt ist, beschrieben werden. Dieser Code kann beispielsweise ein PCM-Code (pulscode modulation) sein (Anspruch 8). Dieses Verfahren ist insbesondere dann effizient, wenn nur wenige Werte eine große Auftrittswahrscheinlichkeit besitzen, wie es z.B. bei der Codierung von Musik in Spektraldarstellung der Fall ist.

Im folgenden soll dies an einem Beispiel erläutert werden. Dabei sei folgende Wahrscheinlichkeitsverteilung gegeben:

Die Aufgabe der vorliegenden Erfindung besteht darin, ein digitales Codierverfahren zu schaffen, das eine verbesserte Codierqualität bei möglichst geringer Bitrate liefert.

Diese Aufgabe wird durch ein digitales Codierverfahren nach Patentanspruch 1 oder 19 gelöst.

| Wert | Wahrscheinlichkeit |
|------|--------------------|
| 0    | 50%                |
| 1    | 30%                |

(fortgesetzt)

| Wert | Wahrscheinlichkeit |
|------|--------------------|
| 2 | 15% |
| 3...15 | zusammen 5%, d.h. je 0,38 % |

Die Entropie, d.h. die kürzest mögliche mittlere Codelänge beträgt hier 1,83275 bit.

Bei einem derartigen Anwendungsfall ist es von Vorteil, einen Huffmancode zu bestimmen, der die Werte 0,1,2 und eine Kennung (im folgenden mit ESC bezeichnet), in der die Werte 3 bis 15 codiert werden, beinhaltet.

| Wert | Huffmancode mit ESC | Huffmancode ohne ESC |
|------|---------------------|----------------------|
| 0 | 0 | 0 |
| 1 | 10 | 10 |
| 2 | 110 | 110 |
| 3 | 111+0011 | 111101 |
| 4 | 111+0100 | 111110 |
| 5 | 111+0101 | 111111 |
| 6 | 111+0110 | 1110000 |
| 7 | 111+0111 | 1110001 |
| 8 | 111+1000 | 1110010 |
| 9 | 111+1001 | 1110011 |
| 10 | 111+1010 | 1110100 |
| 11 | 111+1011 | 1110101 |
| 12 | 111+1100 | 1110110 |
| 13 | 111+1101 | 1110111 |
| 14 | 111+1110 | 1111000 |
| 15 | 111+0111 | 1111001 |

Bei reiner Huffman-Codierung erhält man eine mittlere Codelänge von 1,89 bit, bei einer Codierung mit ESC dagegen eine mittlere Codelänge von 1,9 bit. Die Codeeffizienz wird bei ESC-Codierung zwar geringfügig schlechter, die Tabellengröße für den Coder und den Decoder aber um den Faktor 4 kleiner, so daß die Geschwindigkeit für den Codier- und Decodiervorgang beträchtlich ansteigt.

Verwendet man als Code nach dem ESC-Wert einen modifizierten PCM-Code, so lassen sich ohne Veränderung der mittleren Codelänge sogar die Werte bis 18 codieren.

Huffmancode mit ESC

0
10
110
111+0000
111+0001
111+0010
111+0011
111+0100
111+0101
111+0110
111+0111
111+1000
111+1001
111+1010
111+1011

Huffmancode mit ESC

111+1100

(fortgesetzt)

| Huffmancode mit ESC |
|---|
| Huffmancode mit ESC |
| 111+1101 |
| 111+1110 |
| 111+0111 |

Im Anspruch 9 ist eine Weiterbildung gekennzeichnet, gemäß der n Spektralkoeffizienten mit n ≥ 2 zu einem n-Tupel zusammengefaßt und gemeinsam mittels eines Optimalcoders codiert werden. Optimalcoder, die jedem Spektralwert ein Codewort verschiedener Länge zuweisen, sind nur in Ausnahmefällen "optimal im Sinne der Informationstheorie". Eine weitere Reduktion der Code-Redundanz kann durch die erfindungsgemäße Codierung gemäß Anspruch 9 dadurch erreicht werden, daß wenigstens einem Paar von Spektralwerten ein Codewort zugeordnet wird. Die Redundanzverminderung ergibt sich zum einen daraus, daß die beiden gemeinsam codierten Spektralwerte statistisch nicht unabhängig sind, zum anderen aus der Tatsache, daß bei der Codierung von Paaren von Werten eine feinere Anpassung des Codebuchs bzw. der Codetabelle an die Signalstatistik erfolgen kann.

Dies soll im folgenden an einem Beispiel erläutert werden:

Zunächst sei ein Entropiecoder (Optimalcoder) betrachtet, der Einzelwerten einzelne Codeworte zuordnet:

| Datenwort | Häufigkeit | Codewort | Häufigkeit * Codelänge |
|---|---|---|---|
| 0 | 70 % | 0 | 0,7 |
| 1 | 30 % | 1 | 0,3 |

Es ergibt sich eine mittlere Codewortlänge von 1.

Bei Betrachtung der Wahrscheinlichkeiten von Paaren von Abtastwerten ergibt sich folgender Optimalcodierer:

| Datenwort | Häufigkeit | Codewort | Häufigkeit * Codelänge |
|---|---|---|---|
| 00 | 50% | 0 | 0,50 * 1 |
| 01 | 20% | 10 | 0,20 * 2 |
| 10 | 20% | 110 | 0,20 * 3 |
| 11 | 10% | 111 | 0,10 * 3 |
| | | | = 1,8 |

Die mittlere Codewortlänge pro Einzelwert ergibt sich aus der Summe der Terme "Häufigkeit * Codewortlänge", geteilt durch 2 (wegen der Codierung von Paaren von Werten). Sie ist im Beispiel 0,9. Dies ist weniger, als bei der Codierung von Einzelwerten bei Annahme derselben Signalstatistik erreichbar ist. Die Codierung von Paaren von Spektralwerten geschieht z.B. dadurch, daß der jeweils erste Spektralwert als Zeilennummer und der zweite Werte eins Paars als Spaltennummer verwendet wird, um in einer Codetabelle das jeweilige Codewort zu adressieren.

Vergrößert man die Anzahl der zusammen codierten Werte weiter, so ergibt sich im Mittel eine kleinere Codewortlänge, z.B. für 4-Tupel:

| Datenwort | Häufigkeit | Codewort | Häufigkeit*Codelänge | |
|---|---|---|---|---|
| 0000 | 25 % | 10 | 0,25 * 2 = | 0,5 |
| 0001 | 10 % | 000 | 0,1 * 3= | 0,3 |
| 0010 | 10 % | 010 | 0,1 * 3 = | 0,3 |
| 0011 | 5 % | 11101 | 0,05 * 5 = | 0,2 |
| 0100 | 10 % | 011 | 0,1 * 3 = | 0,3 |
| 0101 | 4 % | 11100 | 0,04 * 5 = | 0,2 |
| 0110 | 4 % | 11001 | 0,04 * 5 = | 0,2 |
| 0111 | 2 % | 00100 | 0,02 * 5= | 0,1 |
| 1000 | 10 % | 1111 | 0,1 * 4= | 0,4 |
| 1001 | 4% | 11011 | 0,04 * 5= | 0,2 |

(fortgesetzt)

| Datenwort | Häufigkeit | Codewort | Häufigkeit*Codelänge | |
|---|---|---|---|---|
| 1010 | 4% | 11010 | 0,04 * 5= | 0,2 |
| 1011 | 2 % | 110001 | 0,02 * 6 = | 0,12 |
| 1100 | 5 % | 0011 | 0,05 * 4 = | 0,2 |
| 1101 | 2 % | 110000 | 0,02 * 6= | 0,12 |
| 1110 | 2 % | 001011 | 0,02 * 6 = | 0,12 |
| 111 | 1 % | 001010 | 0,01 * 6 = | 0,06 |
| | | | | 3,57 |

Die mittlere Codelänge beträgt also im Beispiel 3,57/4 = 0,89 bit.

Ferner ist es auch möglich, eine gemeinsame Codierung gemäß Anspruch 10 dadurch auszuführen, daß Spektralkoeffizienten gleicher Nummer aus aufeinanderfolgenden Blöcken zusammengefaßt und gemeinsam codiert werden. Dies soll im folgenden an einem Beispiel erläutert werden, bei dem zur Vereinfachung zwei Datenblöcke gemeinsam codiert werden; auf die gleiche Weise können aber auch mehr Datenblöcke zusammengefaßt werden:

Es seien x(1 ),x(2),...,x(n) die Frequenzkoeffizienten eines Blockes, y(1),y(2),...,y(n) die des darauf folgenden Blokkes.

1) Die zu codierenden Spektralwerte zweier aufeinanderfolgender Datenblöcke werden zusammen codiert. Dazu wird aus jedem der beiden Blöcke der quantisierte Spektralwert mit der gleichen Nummer genommen und dieses Paar codiert, d.h. zeitlich aufeinanderfolgende Werte der gleichen Frequenz werden zusammen codiert. Die Korrelation zwischen diesen ist bei quasistationären Signalen sehr groß, d.h. ihr Betrag variiert nur wenig. Die dazugehörige Quantisiererinformation ist für beide Datenblöcke wegen der gemeinsamen Codierung nur einmal erforderlich.

Es werden die Paare (x(1) y(1), (x(2)),..., (x(n) y (n) ) zusammen codiert.

2) Die Beträge zweier aufeinander folgender Spektralwerte eines Blockes sind bei "glatten" Spektren miteinander korreliert. Für solche Signale ist es sinnvoll zwei Spektralwerte eines Blocks zusammen zu codieren.

Es werden die Paare (x(1) x(2)), (x(3)x(4)) (x(n-1)x(n) ) zusammen codiert. Abhängig von der Transformation sind auch andere Zusammenfassungen von Werten sinnvoll.

3) Die Umschaltung zwischen 1) und 2) kann zum Beispiel durch ein Kennbit übertragen werden.

Für mehr als zwei gemeinsam codierte Werte können beide Möglichkeiten kombiniert werden: Für 4-Tupel sind z.B. folgende Möglichkeiten sinnvoll:

a) je ein Wert aus vier aufeinanderfolgenden Blöcken
b) je zwei Werte aus zwei aufeinanderfolgenden Blöcken
c) vier Werte aus einem Block

Bei den Fällen a) und b) kann man Zusatzinformation einsparen.

Selbstverständlich ist es nicht nur möglich, daß die Codierung durch Bildung von Paaren oder n-Tupeln von je einem Spektralwert jedes Datenblocks geschieht oder daß die Codierung durch Bildung von n-Tupeln von mehr als einem Spektralwert jedes Datenblocks erfolgt, sondern es ist auch möglich, daß zur Bildung der Paare oder n-Tupel von Spektralwerten zwischen Paaren oder n-Tupeln von aufeinanderfolgenden Datenblöcken und Paaren oder n-Tupeln von in der Zählung nach Frequenzwerten aufeinanderfolgenden Spektralwerten umgeschaltet wird.

Gemäß Anspruch 11 werden Zusatzinformationen übertragen: Im OCF-Verfahren, das in der einleitend genannten WO 88/ 01811 beschrieben ist, werden getrennte Werte für einen Faktor der Pegelsteuerung, die Anzahl der in der inneren Schleife erfolgten Iterationen sowie ein Maß für die spektrale Ungleichverteilung (spectral flatness measure sfm) vom Coder zum Decoder übertragen. Erfindungsgemäß wird aus diesen Werten ein gemeinsamer "Gesamtverstärkungslaktor" ermittelt und zum Empfänger übertragen. Die Berechnung des Gesamtverstärkungsfaktors erfolgt, indem alle Einzelwerte als Exponenten eines bestimmten Zahlenwertes ausgedrückt und die Faktoren zueinander addiert werden.

Dies soll im folgenden anhand eines Beispiels erläutert werden:

Es seien folgende Verstärkungsoperationen mit dem Signal möglich (a,b,c sind ganze Zahlen):

1) Pegelanpassung: Verstärkungsstufen mit $2^a$

2) Quantisierung:

a) Startwert für Quantisierer in Stufen zu $(\sqrt[4]{2})^c = 1{,}682^b$

b) Vergröberung des Quantisierers in Stufen zu $(\sqrt[4]{2})^c = 1{,}189^c$

Die Quantisierung entspricht einer Division, d.h. einer Abschwächung. Deshalb müssen so gebildete Faktoren negativ genommen werden.

Der gemeinsame Faktor dafür beträgt also $f = \sqrt[4]{2}$.

zu 1)

$$f^{4a} = 2^a$$

zu 2a)

$$f^{3b} = (\sqrt[4]{8})^b$$

zu 2b)

$$f^c = (\sqrt[4]{2})^c$$

Der Gesamtverstärkungsfaktor beträgt damit $f^{4a-3b-c}$, nur der ganzzahlige Exponent wird zu Decoder übertragen. Die Anzahl der nötigen Bit ist durch die Wortlänge der Eingangsdaten (i.a. 16 bit) und die Transformationslänge (ergibt maximale Dynamik) bestimmt.

Weiterhin ist es möglich, der Zusatzinformation eine variable Datenrate zuzuweisen (Anspruch 13):

Die Korrekturfaktoren, mit denen die Einhaltung der erlaubten Störung erreicht wird, müssen als zusätzliche Pegelinformationen je Frequenzgruppe zum Empfänger übertragen werden. Erfindungsgemäß wird eine Reduktion der mittleren dazu notwendigen Datenrate dadurch erreicht, daß in einem Steuerwort die Länge der folgenden Datenworte codiert wird und jeweils nur die zur Übertragung notwendige Wortlänge verwendet wird. Dies soll im folgenden ebenfalls an einem Beispiel erläutert werden:

| | |
|---|---|
| Annahmen: Zahl der Frequenzgruppen: | 3 |
| maximale Zahl der Iterationen | 8 |

Übertragen wird die Anzahl der Verstärkungen pro Frequenzgruppe. Ohne die variable Datenrate der Zusatzinformation wären dazu 3*3 = 9 bit notwendig. Es werde (im Beispiel) die maximale Zahl der Verstärkungen folgendermaßen verschlüsselt:

| | |
|---|---|
| keine Verstärkung | 0 |
| höchstens eine Verstärkung | 1 |
| höchstens drei Verstärkungen | 2 |
| höchstens sieben Verstärkungen | 3 |

Das jeweilige Codewort gibt direkt die Zahl der Bits an, die notwendig sind, um den maximalen Verstärkungswert zu codieren.

Das Ergebnis der psychoakustischen Iterationsschleife sei im Beispiel (0 0 2) d.h. die Frequenzgruppe 3 wurde zweimal verstärkt, die anderen Frequenzgruppen nicht. Dies kann mit folgender Bitfolge codiert werden: 10 00 00 10, also mit insgesamt 8 bit.

Gemäß Anspruch 14 wird ebenfalls in an sich bekannter Weise ein Codier verwendet, der nach einem sogenannten Huffman-Code arbeitet. Erfindungsgemäß werden nunmehr jedoch n-Codetabellen mit $n \geq 1$ und mit unterschiedlicher Länge verwendet, die dem jeweils zu codierenden akustischen Signal angepaßt sind. Zusammen mit den codierten Werten wird die Nummer der verwendeten Codetabelle übertragen bzw. gespeichert.

Die mittlere Codelänge eines Huffmancodes hängt nämlich von der Anzahl der verschiedenen Zeichen im Code ab. Deshalb ist es sinnvoll, einen Huffmancode zu wählen, der nicht mehr als die nötige Anzahl an Werten enthält.

Wählt man als Auswahlkriterium für die Codetabelle den maximal zu codierenden Wert, so können alle aktuell vorkommenden Werte codiert werden.

Hat man mehrere Codebücher bzw. Codetabellen zur Verfügung, so kann man anhand der zu codierenden Werte die beste Tabelle auswählen und als Zusatzinformation die Codetabellen-Nummer übertragen. Eine Vorauswahl unter den Codetabellen kann über den maximal zu codierenden Wert geschehen.

Nur zur Ergänzung sei angefügt, daß beispielsweise sehr rauhe Spektren, wie sie von Blech-Blasinstrumenten erzeugt werden, eine andere Statistik, bei der kleine Werte häufiger vorkommen, als glatte Spektren haben, wie sie beispielsweise von Streichinstrumenten oder Holzblasinstrumenten erzeugt werden.

Im Anspruch 15 ist eine Weiterbildung gekennzeichnet, bei der zusätzlich oder anstelle der vorstehend genannten Zuordnung von verschiedenen Tabellen unterschiedlichen spektralen Bereichen unterschiedliche Codetabellen zugeordnet werden. Bei Spektren mit einem ausgeprägten Maximum bringt es nämlich einen Gewinn, dieses in einzelne Bereiche zu teilen und für jeden Teilabschnitt einen optimalen Huffmancode zu wählen.

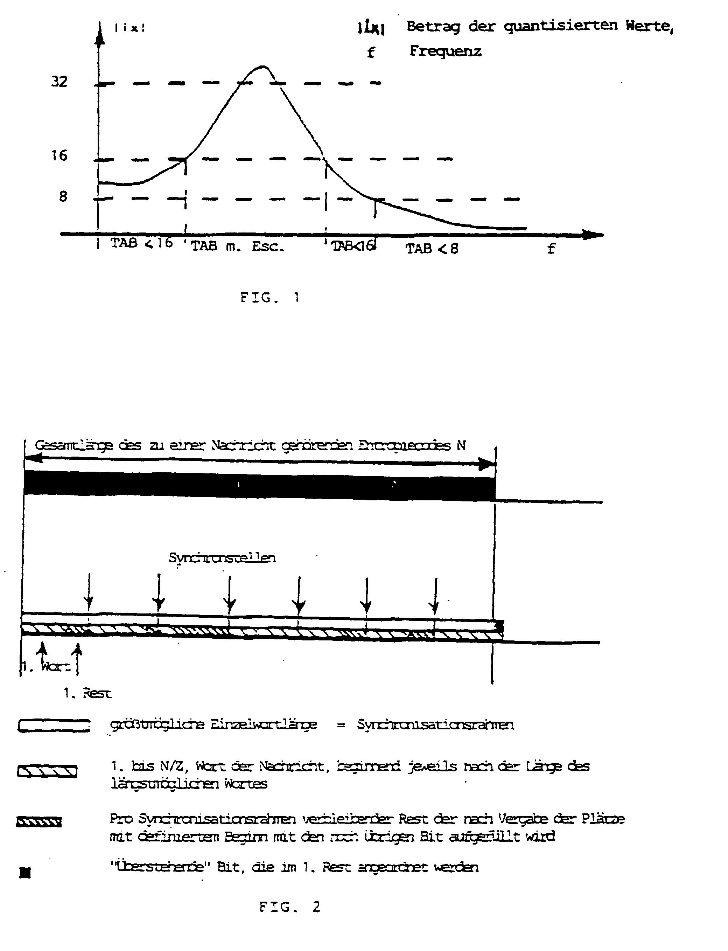

Figur 1 zeigt ein derartiges Spektrum, bei dem sich das Maximum des Spektrums etwa in der Mitte des Spektralbereichs befindet. Hier kann man beispielsweise den Bereich in vier Bereiche teilen:

Im ersten Bereich wird ein Huffmancode mit 16 Werfen, im zweiten ein Code mit mehr als 32 Werten, im dritten Wiederum ein Code mit 16 Werten und im vierten Bereich ein Code mit 8 Werten verwendet. Dabei ist es bevorzugt, wenn bei der Codetabelle mit mehr als 32 Werten eine Tabelle gemäß Anspruch 1 verwendet wird, bei der Codewörter mit größerer Wortlänge als die durchschnittliche Wortlänge durch eine gemeinsame Kennung und einen nachfolgenden PCM-Code beschrieben werden. Dies ist in Figur 1 durch "TAB mit ESC" bezeichnet.

Die Huffman-Codes werden bei dem bezeigten Beispiel nach dem Maximum der Abschnitte ausgewählt, wobei Codes jeweils für 2,4,8 usw. Werte zur Verfügung stehen. Ohne diese Aufteilung müßte der Code für mehr als 32 Werte auf das gesamte Spektrum Anwendung finden, so daß die benötigte bit-Zahl für den Block deutlich höher wäre.

Als Zusatzinformation müssen die Aufteilungspunkte und die Codetabellennummer für jeden Abschnitt übertragen werden.

Die Auswahl des Huffmancodes für jeden Abschnitt kann insbesondere nach den im Anspruch 10 angegebenen Überlegungen erfolgen.

Im Anspruch 16 ist eine vorteilhafte Möglichkeit der Decodierung der bereits genannten Huffmancodes angegeben: Hierzu wird der Baum, der sich bei der Erstellung des Codes ergibt, nachgebildet. Wegen der Bedingung, daß kein Codewort der Anfang eines weiteren Codewortes sein kann, ergibt sich vom "Stamm" ausgehend nur ein möglicher Weg zum zugehörigen Codewort. Um zum Codewort zu gelangen wird, von vorne beginnend, jeweils ein Bit des Codewortes benützt, um bei Verzweigungen im Baum den Weg festzulegen. Die praktische Realisierung erfolgt mittels einer Tabelle von Adresspaaren, die immer vom ersten Paar beginnend abgearbeitet wird. Der erste Wert des Paares enthält dabei jeweils die Adresse der nächsten Verzweigung, die im Falle einer "0" im zu dekodierenden Wert anzuspringen ist, der zweite Wert die Adresse der Verzweigung im Falle einer "1". Jede Adresse wird als solche markiert. Gelangt man zu einem Tabellenwert ohne diese Markierung, so ist ein Codewort erreicht. Der Tabellenwert entspricht in diesem Fall dem zu dekodierenden Wert. Das nächste folgende zu dekodierende Bit ist folglich das erste Bit des folgenden Codewortes. Mit diesem beginnend erfolgt ein erneutes Durchlaufen der Tabelle vom ersten Adresspaar an.

Im folgenden soll hierfür ein Beispiel erläutert werden:

| Wert | Huffmancode |
|------|-------------|
| 0 | 00 |
| 1 | 01 |
| 2 | 100 |
| 3 | 101 |
| 4 | 1100 |
| 5 | 1101 |
| 6 | 1110 |
| 7 | 1111 |

Codebaum:

| Dekodiertabelle: | | | | | | | |
|---|---|---|---|---|---|---|---|
| &0 | &1 | &2 | &3 | &4 | &5 | &6 | &7 |
| &1/&4 | &2/&3 | 0/-- | 1/-- | &5/&8 | &6/&7 | 2/-- | 3/-- |
| &8 | &9 | &10 | &11 | &12 | &13 | &14 | |
| &9/&12 | &10/&11 | 4/-- | 5/-- | &13/&14 | 6/-- | 7/-- | |

Das Zeichen & kennzeichnet eine Adresse.

| Dekodierbeispiel : | 1 | 1 | 0 | 1 | = 5 |
|---|---|---|---|---|---|
| &0 | 1 | | | | ==> &4 |
| &4 | | 1 | | | ==> &8 |
| &8 | | | 0 | | ==> &9 |
| &9 | | | | 1 | ==> &11 |
| &11 | | | | | ==> keine Adresse |
| | | | | | ==> dek. Wert = 5 |

Im Fall, daß der Huffmancode für Wertepaare erstellt wurde, kann am zweiten, im obigen Beispiel freien Tabellenplatz, der zugehörige zweite Wert untergebracht werden. Sinngemäß kann dieses Verfahren auch zur Dekodierung für Huffmancodes verwendet werden, die mehr als zwei Werte zusammen codieren.

Bei Codierungen, bei denen der Beginn eines Codewortes nur durch das Ende des vorhergehenden Codewortes bestimmt ist (wie dies beispielsweise beim Huffmancode der Fall ist) führt ein Übertragungsfehler zu einer Fehlerfortpflanzung.

Man ordnet zunächst einen Teil der Codewörter in einem Raster an, dessen Länge beispielsweise größer oder gleich der des längsten Codewortes ist, so kommt es für diesen Teil der Codewörter zu keiner Fehlerfortpflanzung mehr, da ihr Beginn nicht mehr durch das Ende des vorhergehenden Codewortes bestimmt ist. Die restlichen Codewörter werden in die verbleibenden Lücken verteilt. Ein Beispiel hierfür zeigt Figur 2. Wird die verwendete Codetabelle derart aufgebaut, daß man aus den ersten Stellen der Codewörter bereits auf den Bereich der Codetabelle schließen kann, so kann die Länge des verwendeten Rasters auch kleiner als die Länge des längsten Codewortes sein. Die nicht mehr ins Raster passenden Stellen werden wie die restlichen Codewörter in die verbleibenden Lücken verteilt. Durch die Verwendung dieser kürzeren Rasterlänge lassen sich mehr Codewörter in diesem Raster anordnen und die Feherfortpflanzung beschränkt sich auf die letzten Stellen dieser Codewörter, die durch die oben beschriebene Struktur der Codetabelle nur nur von untergeordneter Bedeutung sind. Diese Umsortierung führt zu keiner Verminderung der Codeeffizienz.

Auch dies soll im folgenden anhand Beispiels erläutert werden:

| Wert | Codewort |
|---|---|
| 0 | 0 |
| 1 | 100 |
| 2 | 101 |
| 3 | 110 |
| 4 | 111 |

Bereits die ersten beiden Stellen entscheiden, ob der Wert aus dem Bereich "0", "1-2" oder "3-4" ist. Daher wird eine Rasterlänge von 2 gewählt. Es soll folgende Wertefolge codiert übertragen werden:

| Wertefolge | 2 | 0 | 4 | 0 |
|---|---|---|---|---|
| Codewörter | 101 | 0 | 111 | 0 |

ohne Codesortierung ergibt ein Bitfehler im ersten Bit die Bitfolge

| | 001 | 0 | 111 | 0 |
|---|---|---|---|---|
| zerlegt also | 0 | 0 | 101 | 110 |

(fortgesetzt)

|  | 001 | 0 | 111 | 0 |
|---|---|---|---|---|
| decodiert | 0 | 0 | 2 | 3 |

mit Codesortierung (Rasterlänge 2) ergibt sich folgende Bitfolge

| zunächst | 10 | 0 | 11 | 0 |
|---|---|---|---|---|
| Rest | 1 |  | 1 |  |
| Rest in Lücken | 10 | 0 1 | 11 | 0 1 |

mit einem Bitfehler im ersten Bit ergibt sich die Bitfolge

|  | 00 | 01 | 11 | 01 |
|---|---|---|---|---|
| Bereich | 0 | 0 | 3-4 | 0 |

d.h. nur für das gestörte Codewort konnte der Bereich nicht mehr richtig dekodiert werden.

Weiterhin ist es möglich, wichtige Nachrichtenteile in einem festen Raster anzuordnen:

Die Übertragungssicherheit kontinuierlich aufeinander folgender Nachrichten unterschiedlicher Länge mit Nachrichtenteilen unterschiedlicher Wichtigkeit läßt sich folgendermaßen verbessern: Die mittlere Nachrichtenlänge des kontinuierlichen Bitstromes stellt den Abstand der Punkte eines äquidistanten Rasters dar. Die wichtigen Nachrichtenteile werden nun in diesem festen Raster angeordnet. Zusätzlich wird in diesem wichtigen Informationsteil die Position des zugehörigen weniger wichtigen Teils mit übertragen. Durch den äquidistanten Abstand der wichtigten Information ist im Falle eines Übertragungsfehlers die Neusynchronisation leichter zu erreichen.

Im folgenden soll die Fehlerbegrenzung bei Entropiecodes erläutert werden:

Im Falle eines Bitfehlers im Entropiecode gehen im Fehlerfall in der Regel alle der Fehlerstelle folgenden Informationen verloren. Durch Markierung des Blockanfangs mit einem bestimmten Bitmuster und der zusätzlichen Übertragung der Entropiecodelänge läßt sich der entstehende Fehler auf den Nachrichtenblock, der den Bitfehler enthält, begrenzen. Dies geschieht folgendermaßen:

Nach erfolgreicher Decodierung einer Nachricht müßte der Beginn des nächsten Nachrichtenblocks und damit eine Blockanfangsmarkierung folgen. Ist dies nicht der Fall, wird mit Hilfe der Entropiecodelänge überprüft, ob die Decodierung sich an der anach der Entropiecodelänge zu erwartenden Stelle befindet. Ist dies der Fall, wird ein Fehler in der blockanfangsmarkierung angenommen und korrigiert. Ist dies nicht der Fall, wird geprüft, ob an der durch die Entropiecodelänge angegebene Bitstromposition eine Blockanfangsmarkierung folgt, die dann mit großer Wahrscheinlichkeit den Beginn des nächsten Blocks markiert. Wird keine Blockanfangsmarkierung getroffen liegen mindestens 2 Fehler (Decodierung/Blockanfangsmarkierung oder Entropiecodelänge/Decodierung oder Blockanfangsmarkierung/Entropiecodelänge) vor und es muß neu synchronisiert werden.

Weiterhin ist es möglich, einen Synchronisationsschutz bzw. eine Synchronisationserkennung vorzusehen:

Bei kontinuierlichen Datenströmen, die aus Blöcken unterschiedlicher Länge zusammengesetzt sind, ergibt sich das Problem, daß Synchronwörter zur Kennzeichnung der Blockanfänge sich auch zufällig im Datenstrom befinden können. Die Wahl sehr langer Synchronwörter verringert zwar diese Wahrscheinlichkeit, kann sie aber zum einen nicht zu null setzen und führt zum anderen zu einer Verminderung der Übertragungskapazität. Ein Paar von Schaltungen, das einem gefundenen Synchronwort am Blockanfang eine "1" und innerhalb eines Blockes eine "0" anhängt (bzw. umgekehrt am Blockanfang eine "0" und sonst eine "1"), ist aus der Literatur bekannt (z.B.: Intel "BITBUS"-frameformat). Die Anwendung zur Übertragung von codierten Musiksignalen ist erfindungsgemäß. Angepaßt an diese Anwendung enthält die "Synchronisationserkennung" die Möglichkeit, in Bereichen, in denen ein Synchronwort erwartet wird, dieses als solches zu akzeptieren, auch wenn es durch Übertragungsfehler in einigen Stellen verändert wurde.

Es ist eine Beschränkung der Maximalzahl der Iterationen angegeben:

Ziel ist die Begrenzung der zur Quantisiererkennzeichnung zu übertragenden Bits. Ausgehend von einem Quantisiererstartwert ist nur eine begrenzte Abweichung von diesem Startwert zugelassen, die mit n Bit dargestellt werden kann. Zur Einhaltung dieser Bedingung wird vor jedem Durchgang durch die äußere Schleife geprüft, ob noch gewährleistet ist, daß ein weiter Aufruf der inneren Schleife mit einem gültigen Ergebnis beendet werden kann.

Auch dies soll im folgenden anhand eines Beispiels erläutert werden:

Ausgehend vom Quantisiererstartwert wird der Quantisierer in Stufen von $q = \sqrt[4]{2}$ verändert. Im ungünstigsten Fall werden in der äußeren Schleife alle Frequenzgruppen verstärkt um den Faktor 2. Sind noch 4 Vergröberungen des Quantisierers um $q = \sqrt[4]{2}$ möglich, ist gewährleistet, daß die innere Schleife mit einem in den erlaubten Bitrahmen passenden Ergebnis beendet wird. Zur Übertragung sind für die Abweichung vom Startwert 5 Bit vorgesehen, so daß als Abweichung vom Startwert maximal 31 möglich ist. Die innere Schleife wird also nicht mehr aufgerufen, falls bereits 28 oder mehr erreicht ist, da in diesem Fall nicht mehr sichergestellt ist, daß mit der erlaubten Bitzahl der Block codiert werden kann.

Durch die Anspruch 1 angegebene Maßnahme wird die Psychoakustik dadurch verbessern, daß psychoakustische Maßnahmen über mehrere Blöcke angewendet werden. Eine Weiterbildung ist im Anspruch 2 angegeben:

Das verwendete, erfindungsgemäße Verfahren soll anhand eines Beispiels beschrieben werden. Um das Beispiel einfach zu halten, sei die Zahl der Frequenzgruppen zu 2 angenommen. Die Werte für die jeweils erlaubte Störung etc. sind ebenfalls Beispielswerte, die in der praktischen Ausführung des Codierverfahrens anders gewählt werden:

Es sei die erlaubte Störung = 0,1 * Signalleistung je Frequenzgruppe. Die Leistungswerte sind ohne Maßangabe angegeben. Der Maßstab kann willkürlich gewählt werden, da nur Verhältnisangaben und nicht der Absolutbetrag der Leistungswerte Verwendung finden.

|  | Frequenzgruppe | Leistung | erlaubte Störung |
|---|---|---|---|
| erster Block: | FG 1: | 50. | 5. |
|  | FG 2: | 60. | 6. |
| zweiter Block: | FG 1: | 1000. | 100. |
|  | FG 2: | 100. | 10. |

Der "Vergessensfaktor", mit dem berücksichtigt wird, daß die Signalleistung des jeweils vorhergehenden Blocks weniger in die Berechnung der aktuell erlaubten Störung eingeht als die Signalleistung des aktuellen Blocks, sei zu 2 gewählt. Die erlaubte Störung im zweiten Block wird dann berechnet als Minimum der aus den Daten des zweiten Blocks errechneten erlaubten Störung und der aus den Daten des ersten Blocks errechneten, korrigiert um den Vergessensfaktor. Es ergibt sich im Beispiel für den zweiten Block für die Frequenzgruppe FG 1: min(2*6, 100)=12 und für FG 2:min (2*5, 10)=10 als erlaubte Störung.

Im einfachsten Fall wird, wie schon in der WO 88/01811 beschrieben, für jeden Block eine bestimmte Datenrate (Bitzahl) zur Verfügung gestellt. Sofern nicht die gesamte Datenrate zur Codierung des Blockes Verwendung findet, werden die "übriggebliebenen" Bits der für den nächsten Block zur Verfügung stehenden Bitzahl dazugefügt. Dies wird als "Bitsparkasse" bezeichnet.

In der erfindungsgemäßen Erweiterung dieses Verfahrens werden eine maximale untere und obere Summenabweichung der Datenrate zugelassen. Die Summenabweichung der Datenrate (Abweichung der Bitzahlsummen der Datenblöcke von der aus der gewünschten konstanten Datenrate errechenbaren Bitzahlsumme) wird "Bitsparkasse" genannt.

Die Bitsparkasse wird gefüllt durch die im Normalbetrieb jeweils nicht vollständige Nutzung der aktuell zur Verfügung stehenden Bitzahl. Solange nicht eine obere Grenze der Bitsparkasse (=untere Grenze der Abweichung der Summenbitzahl) erreicht ist, werden jedem Block von neuem nur die aus der mittleren Datenrate errechenbare Bitzahl zur Verfügung gestellt, nicht jedoch die im jeweils vorhergehenden Block "übriggebliebenen" Bits.

Wenn z.B. bei starken Pegelanstiegen des Signals (z.B. Triangel) für einen Datenblock aufgrund der Berücksichtigung der erlaubten Störung des letzten Datenblocks (siehe oben) eine deutlich geringere erlaubte Störung errechnet wird, als dies ohne die Berücksichtigung der Daten des letzten Blocks der Fall wäre, dann werden der inneren Iterationsschleife des aktuellen Blocks mehr Bits zur Codierung zur Verfügung gestellt und der Wert der Summenabweichung ("Bitsparkasse") entsprechend korrigiert. Die Zahl der zusätzlichen Bits wird so gewählt, daß die maximale Summenabweichung ("Mindeststand der Bitsparkasse") nicht überschritten werden kann. Im obigen Beispiel könnte die Zahl der zusätzlichen Bits z.B. wie folgt berechnet werden:

In der ersten Frequenzgruppe des zweiten Blocks wäre die erlaubte Störung = 100., wenn die Daten des ersten Blocks nicht berücksichtig würden. Das Verhältnis zwischen erlaubter Störung mit und ohne Berücksichtigung der Daten des letzten Blockes ist also 100/12 = 8.33, das sind ca. 10*log (8.33) = 9.2dB.

Wenn angenommen wird, daß das Quantisierungsrauschen bei Quantisierung mit einem zusätzlichen Bit pro Wert um ca. 6dB gesenkt wird, dann sind pro Spektralwert der Frequenzgruppe ca. 1,5 bit notwendig, um die geringere erlaubte Störung zu erreichen. Die Zahl der aus der Bitsparkasse zu verwendeten Bits beträgt also im Beispiel 1,5* Zahl der Spektralwerte der Frequenzgruppe.

Die Synchronisation von Ausgangs- und Eingangsbittakt: erfolgt folgender maßen:

Bei Codiersystemen mit beliebigem Verhältnis von Eingangs- zu Ausgangsbittakt besteht das Problem, daß die zu vergebende Bitzahl ein unendlicher Bruch sein kann. Damit ist die Synchronisation durch eine Langzeitmittelung der zu vergebenden Bitzahl, die bei einem endlichen Bruch möglich wäre, ausgeschlossen. Ein Auseinanderlaufen von Eingang und Ausgang wird durch eine Regelung verhindert, die den Abstand von Ein- und Ausgabezeiger eines Pufferspeichers beobachtet. Wird der Abstand geringer, wird die Bitzahl verringert und umgekehrt. Bei einem konstanten Verhältnis von Eingangs- zu Ausgangsbittakt bzw. bei einem um einen konstanten Mittelwert variirenden Verhältnis von Eingangs- zu Ausgangsbittakt ist es ausreichend die zu vergebende Bitzahl um jeweils 1 Bit zu variieren. Die maximale Abweichung vom Mittelwert bestimmt jedoch die vorzusehende minimale Puffergröße. Dies soll anhand von Fig. 4 an einer konkreten OCF-Implementierung erläutert werden:

Eingangsdaten sind Abtastwerte, die mit konstanter Frequenz angeliefert werden. Der Ausgang ist an einen Kanal mit konstanter Bitrate angeschlossen. Damit ist ein konstantes mittleres Verhältnis von Eingangs- zu Ausgangsbittakt vorgegeben. Im Coder kann die pro Block an den Ausgang weitergegebene Bitzahl, bedingt durch die Bitsparkasse, schwanken. D.h. es gibt Blöcke für die mehr oder weniger als die durchschnittliche pro Block verfügbare Bitzahl (== Eingangsbittakt/Ausgangsbittakt*Blocklänge), die eine nichtnatürliche Zahl sein kann, an den Ausgang weitergegeben wird. Diese Schwankung wird durch ein FIFO (Ringpuffer) am Ausgang ausgeglichen. Die FIFO-Länge ist entsprechend dem maximalen Inhalt der Bitsparkasse gewählt. Ist die durchschnittliche pro Block verfügbare Bitzahl eine nichtnatürliche Zahl, muß entweder die nächst größere bzw. die nächst kleinere natürliche Bitzahl pro Block vergeben werden. Wird die nächst größere bzw. nächst kleinere gewählt, werden die FIFO-Eingangs- und Ausgangszeiger aufeinanderzulaufen bzw. auseinanderlaufen. Um den Sollabstand werden nun in beide Richtungen Sollabstände definiert, bei deren Überschreiten von nächst größeren zum nächst kleineren (oder umgekehrt) umgeschaltet wird. Dabei wird als Startwert für die zu vergebende Bitzahl eine dieser beiden Näherungen vorgegeben. Bei ausreichender Puffergröße läßt sich diese Regelung auch dazu benützen, diesen Startwert zu ermitteln. Im Zusammenhang mit der Bitsparkasse muß vor dem Pointervergleich der Inhalt der Bitsparkasse berücksichtigt werden.

Wird die Bitzahl um mehr als ein Bit variiert, ist dieses Verfahren auch dann anzuwenden, wenn kein konstanter Mittelwert vorliegt. Aus der Differenz der Pointer wird in diesem Fall die Korrekturbitzahl berechnet.

Die verwendeten Blöcke werden dadurch nicht überfüllt, daß von den für einen Block zur Verfügung stehenden Bits die Anzahl der von den Zusatzdaten benötigten Bits, die auf dem selben Kanal übertragen werden, abgezogen werden.

Die Ansprüche 3 und 4 geben Weiterbildungen an, die u.a. die Nachverdeckung verbessern: Erfindungsgemäß wird zur Berechnung der erlaubten Störung die Signalenergie in den vorhergehenden Datenblöcken einbezogen, indem die erlaubte Störung von einem Datenblock zum nächsten nach Beachtung sämtlicher anderer Parameter zur Bestimmung der aktuellen erlaubten Störung jeweils höchstens um einen bestimmten Faktor abnimmt.

Auch dies soll im folgenden anhand eines Beispiels erläutert werden:

Die erlaubte Störung in der Frequenzgruppe 1 sei im Block 1 gleich 20. Im Block 2 sei die Signalleistung in FG1 gleich 50. Bei einer angenommenen erlaubten Störung von 0,1* Leistung in der Frequenzgruppe wäre die erlaubte Störung gleich 5. Wenn der "Nachverdeckungsfaktor" als -3 dB pro Block angenommen wird, das entspricht einer Halbierung der Leistung, dann wird die erlaubte Störung im Block zu 10(= 0,5 * 20) berechnet.

Ferner ist es möglich, ein Anpassung an verschiedene Bitraten vorzunehmen:

Der Iterationsblock der OCF verteilt die für den Block zur Verfügung stehende Bitzahl entsprechend der Vorgabe der "erlaubten Störung" je Frequenzgruppe. Zur Optimierung des Ergebnisses wird die Berechnung der "erlaubten Störung" der zur Verfügung stehenden Bitzahl angepaßt. Ausgangspunkt ist hierbei die tatsächliche Mithörschwelle, die bei einer "erlaubten Störung" ESO noch nicht verletzt wird. Der für eine bestimmte Bitrate geforderte Störabstand wird so gewählt, daß im Mittel ein gleichmäßiger Verlauf des Störspektrums erreicht wird. Je niedriger die zu vergebende Gesamtbitzahl liegt, umso weniger Störabstand je Gruppe wird gefordert. Dabei wird zwar in einer mit immer niedrigeren Bitraten steigende Anzahl von Blöken die errechnete Mithörschwelle verletzt, doch insgesamt ein gleichmässiger Störverlauf erreicht. Im Gegensatz dazu kann bei höheren Bitraten ein zusätzlicher Sicherheitsabstand zur Mithörschwelle erreicht werden, der z.B. Nachbearbeitung oder Mehrfachcodierung/decodierung des Signals erlaubt.

Als weitere Maßnahme ist eine Bandbreitenbegrenzung durch Löschen bestimmter Frequenzbereiche vor Berechnung der "erlaubten Störung" möglich. Dies kann statisch geschehen oder dynamisch, falls in mehreren Blöcken hintereinander der geforderte Störabstand nur schlecht eingehalten wird.

Bei einem steilem Abfall der Verdeckung zu tiefen Frequenzen hin, d.h. bei der Berechnung der erlaubten Störung ist besonders zu berücksichtigen, daß nur ein geringer Verdekkungseffekt von hohen zu tiefen Frequenzen hin besteht. Die in 1. Näherung berechnete erlaubte Störung wird deshalb, im Falle eines starken Energieanstiegs im Spektrum für die Frequenzgruppen unterhalb des Anstiegs nach unten korrigiert.

Erfindungsgemäß werden bei den gezeigten Codierverfahren die Bereiche, in denen die "erlaubte Störung" größer als die Signalenergie ist, gelöscht. Die entstehende Folge von gelöschten Werten wird entweder durch ein Bit in der Seiteninformation oder durch einen Wert in der Tabelle der möglicher Quantisierungsstufenhöhen für jede Frequenzgruppe in der Seiteninformation codiert.

Weiterhin wird erfindungsgemäß die Quantisiererkennlinie verbessert:

Bei Quantisierung und Rekonstruktion wird die Statistik der unquantisierten Werte beachtet. Diese nimmt in einer gekrümmten Kennlinte streng monoton ab. Dadurch liegt der Erwartungswert jedes Quantisierungsintervalls nicht in der Mitte des Intervalls, sondern näher zu den kleineren Werten verschoben (Fig. 5).

Um den kleinsten Quantisierungsfehler zu erhalten sind zwei Vorgehensweisen möglich:

a) Vorgabe einer Quantisierungskennlinie: Anhand der Quantisierungskennlinie und der statistischen Verteilung der zu quantisierenden Werte wird für jedes Quantisierungsintervall der Erwartungswert bestimmt und als Tabelle für die Rekonstruktion im Decoder verwendet. Der Vorteil dieses Vorgehens liegt in der einfachen Realisierbarkeit und dem geringen Rechenaufwand in Coder und Decoder.

b) Vorgabe der Rekonstruktionskennlinie: Anhand dieser und eines Modells für die Wahrscheinlichkeitsverteilung der Eingangswerte kann eine Quantisiererkennlinie berechnet werden, für die der Erwartungswert jedes Quantisierungsintervalls exakt dem rekonstruiertem Wert dieses Intervalls entspricht. Dies bietet den Vorteil, daß im Decoder keine Tabellen benötigt werden und die Quantisierungskennlinie im Coder an die aktuelle Statistik angepaßt werden kann, ohne daß dies dem Decoder mitgeteilt werden muß.

c) Vorgabe einer Quantisiererkennlinie und Berechnung der Rekonstruktionskennlinie für jeden Wert: Bei gegebener Quantisiererkennlinie und einer Funktion für die Wahrscheinlichkeitsverteilung für die Eingangsdaten kann der Decoder aus diesen jeweils den Rekonstruktionswert berechnen. Dies bietet den Vorteil, daß im Decoder keine Tabellen zur Rekonstruktion benötigt werden. Nachteil dieses Vorgehens ist der höhere Rechenaufwand im Decoder.

## Patentansprüche

1. Digitales Codierverfahren für die Übertragung und/oder Speicherung von akustischen Signalen und insbesondere von Musiksignalen,
bei dem eine Folge von Blöcken von ersten Abtastwerten des akustischen Signals gebildet wird,
bei dem die Folge von Blöcken von ersten Abtastwerten des akustischen Signals mittels einer Transformation blockweise in eine Folge von Blöcken von zweiten Abtastwerten transformiert wird, wobei die zweiten Abtastwerte eines Blocks Spektralkoeffizienten sind, die die spektrale Zusammensetzung der ersten Abtastwerte des akustischen Signals aus einem entsprechenden Block der Folge von Blöcken von ersten Abtastwerten wiedergeben,
bei dem die Folge von Blöcken von zweiten Abtastwerten entsprechend Anforderungen hinsichtlich einer erlaubten Störung mit unterschiedlicher Genauigkeit blockweise quantisiert und teilweise oder ganz mittels eines Codierers codiert wird, und
bei dem bei der Wiedergabe eine entsprechende Decodierung und Rücktransformation erfolgt,
**dadurch gekennzeichnet,**
**daß** eine Berechnung der erlaubten Störung zur Quantisierung der Spektralkoeffizienten eines Blocks von zweiten Abtastwerten von einer erlaubten Störung abhängig ist, die für einen in der Folge von Blöcken von ersten Abtastwerten vorherigen Block von ersten Abtastwerten berechnet wurde.

2. Codierverfahren nach Anspruch 1,
**dadurch gekennzeichnet, dass** zur Berechnung der erlaubten Störung für einen Block von ersten Abtastwerten eine Analyse der Signalenergie in verschiedenen Frequenzgruppen durchgeführt wird, und dass jeweils Werte des in der Folge von Blöcken von ersten Abtastwerten vorhergehenden Blocks, die um einen Vergessens-Faktor korrigiert sind, sowie Werte des aktuellen Blocks von ersten Abtastwerten gemeinsam zur Berechnung der erlaubten Störung herangezogen werden.

3. Codierverfahren nach Anspruch 1 oder 2,
**dadurch gekennzeichnet, dass** zur Berechnung der erlaubten Störung für einen Block von ersten Abtastwerten die Energiewerte des in der Folgen von Blöcken von ersten Abtastwerten vorhergehenden Blocks in der Weise Verwendung finden, dass Spektralkoeffizienten geringer Amplitude, die auf Spektralkoeffizienten höherer Amplitude folgen, weniger genau quantisiert werden.

4. Codierverfahren nach einem der Ansprüche 1 bis 3,
**dadurch gekennzeichnet, dass** die errechnete erlaubte Störung bei Detektierung eines steilen Energieanstiegs zu hohen Frequenzen hin für eine Frequenzgruppe unterhalb des Anstiegs verringert wird.

5. Codierverfahren nach einem der Ansprüche 1 bis 4,
**dadurch gekennzeichnet, dass** in an sich bekannter Weise ein Codierer verwendet wird, bei dem die Auftrittswahrscheinlichkeit eines quantisierten Spektralkoeffizienten mit einer Länge eines Codes derart korreliert ist, dass ein Codewort umso kürzer ist, je häufiger der quantisierte Spektralkoeffizient auftritt, und
dass zur Reduzierung einer Tabellengrösse des Codierers entweder mehreren Elementen einer Folge oder einem Wertebereich ein Codewort sowie gegebenenfalls ein Zusatzcode zugeordnet werden.

6. Codierverfahren nach Anspruch 5,
   **dadurch gekennzeichnet, dass** nur einem Teil des Wertebereichs eines Folgen-Elements direkt ein Codewort zugewiesen wird, und dass allen ausserhalb dieses Teilbereichs liegenden Werten eine gemeinsame Kennung sowie ein besonderer Code zugewiesen wird.

7. Codierverfahren nach Anspruch 5 oder 6,
   **dadurch gekennzeichnet, dass** als Codierer ein Huffmancode verwendet wird.

8. Codierverfahren nach Anspruch 6 oder 7,
   **dadurch gekennzeichnet, dass** der besondere Code ein PCM-Code ist.

9. Codierverfahren nach einem der Ansprüche 1 bis 8,
   **dadurch gekennzeichnet, dass** n Spektralkoeffizienten eines Blocks von zweiten Abtastwerten mit n>/=2 zu einem n-Tupel zusammengefasst und gemeinsam durch Angabe eines Codewortes codiert werden.

10. Codierverfahren nach einem der Ansprüche 1 bis 9,
    **dadurch gekennzeichnet, dass** Spektralkoeffizienten insbesondere gleicher Nummer aus wenigstens zwei aufeinanderfolgenden Blöcken von zweiten Abtastwerten zu einem Paar bzw. einem n-Tupel zusammengefasst und gemeinsam durch Angabe eines Codeworts codiert werden.

11. Codierverfahren nach einem der Ansprüche 1 bis 10, das entsprechend dem OCF-Verfahren arbeitet,
    **dadurch gekennzeichnet, dass** aus den Werten für die Anzahl der durchgeführten Iterationschritte, für die Anfangsquantisierungsstufenhöhe, dem Wert für die Ungleichmässigkeit des Verlaufs des Spektrums sowie weiterer Pegelinformationen aus dem Gang der Berechnung ein Gesamtverstärkungsfaktor berechnet wird, der als Zusatzinformation statt der Einzelwerte zum Empfänger übertragen wird.

12. Codierverfahren nach einem der Ansprüche 11,
    **dadurch gekennzeichnet, dass** die Zusatzinformation über Änderungen einer Quantisierungsstufe zur Einhaltung der erlaubten Störung über mehr als einen Block von ersten Abtastwerten gemeinsam gebildet und übertragen wird.

13. Codierverfahren nach Anspruch 11 oder 12,
    **dadurch gekennzeichnet, dass** die Codierung der Zusatzinformation durch einen Code mit variabler Wortlänge erfolgt.

14. Codierverfahren nach einem der Ansprüche 1 bis 13,
    **dadurch gekennzeichnet, dass** signalabhängig unterschiedliche Codetabellen verwendet werden, und dass zusammen mit den codierten Werten eine Nummer der verwendeten Codetabelle übertragen bzw. gespeichert wird.

15. Codierverfahren nach Anspruch 14,
    **dadurch gekennzeichnet, dass** für verschiedene Spektralbereiche unterschiedliche Codetabellen verwendet werden, und
    dass die Grenzen zwischen den Bereichen fest vorgegeben sind oder signalabhängig ermittelt werden.

16. Codierverfahren nach einem der Ansprüche 1 bis 15,
    **dadurch gekennzeichnet, dass** ein Teil von Codewörtern variabler Länge, die quantisierte Spektralkoeffizienten eines Blocks von zweiten Abtastwerten darstellen, in einem Raster angeordnet wird, und
    dass die restlichen Codewörter in die verbleibenden Lücken verteilt werden, so dass ohne vollständige Decodierung oder bei fehlerhafter Übertragung der Anfang eines Codeworts leichter gefunden werden kann.

17. Codierverfahren nach Anspruch 16,
    **dadurch gekennzeichnet, dass** zur Verbesserung der Übertragungssicherheit kontinuierlich aufeinanderfolgender Nachrichten mit unterschiedlicher Wichtigkeit ein äquidistantes Raster vorgegeben wird, dessen Rasterlänge der mittleren Länge der zu übertragenden Nachrichten entspricht, und
dass die wichtigsten Nachrichtenteile in diesem Raster angeordnet werden, und dass ggflls. zusätzlich zu den wichtigsten Nachrichtenteilen in diesem Raster die Position der weniger wichtigen Nachrichten übertragen wird.

18. Codierverfahren nach einem der Ansprüche 1 bis 17,
**dadurch gekennzeichnet, dass** zur Ermittlung des Beginns eines nächsten Nachrichtenblocks im Falle eines Übertragungsfehlers eine Blockanfangsmarkierung und zusätzlich eine Entropiecodelänge übertragen werden.

19. Digitales Codierverfahren für die Übertragung und/oder Speicherung von akustischen Signalen und insbesondere von Musiksignalen,
bei dem eine Folge von Blöcken von ersten Abtastwerten des akustischen Signals gebildet wird,
bei dem die Folge von Blöcken von ersten Abtastwerten des akustischen Signals mittels einer Transformation blockweise in eine Folge von Blöcken von zweiten Abtastwerten transformiert wird, wobei die zweiten Abtastwerte eines Blocks Spektralkoeffizienten sind, die die spektrale Zusammensetzung der ersten Abtastwerte des akustischen Signals aus einem entsprechenden Block der Folge von Blöcken von ersten Abtastwerten wiedergeben,
bei dem die Folge von Blöcken von zweiten Abtastwerten entsprechend Anforderungen hinsichtlich einer erlaubten Störung mit unterschiedlicher Genauigkeit blockweise quantisiert und teilweise oder ganz mittels eines Codierers codiert wird, und
bei dem bei der Wiedergabe eine entsprechende Decodierung und Rücktransformation erfolgt,
**dadurch gekennzeichnet,**
**dass** für eine Berechnung der erlaubten Störung zur Quantisierung der Spektralkoeffizienten eines Blocks von zweiten Abtastwerten längere Signalabschnitte verwendet werden als in dem entsprechenden Block von ersten Abtastwerten enthalten sind, oder
**daß** eine Berechnung der erlaubten Störung zur Quantisierung der Spektralkoeffizienten eines Blocks von zweiten Abtastwerten von einer erlaubten Störung abhängig ist, die für einen in der Folge von Blöcken von ersten Abtastwerten vorherigen Block von ersten Abtastwerten berechnet wurde, und
wobei für beide Alternativen gilt,
**dass** zur Codierung von einem Block von zweiten Abtastwerten eine tatsächlich zur Verfügung gestellte Bitzahl abhängig von Signaleigenschaften, einer Kapazität des Übertragungskanals oder zur Vereinfachung der Codierung von einer Bitzahlsumme nach oben oder unten abweichen kann, wobei die Bitzahlsumme so errechnet ist, daß eine konstante Datenrate zur Codierung der Blöcke von zweiten Abtastwerten eingehalten wird,
wobei eine Summe von Bitzahlen, die für die Codierung der Blöcke von zweiten Abtastwerten tatsächlich zur Verfügung gestellt wird, von der Bitzahlsumme nach oben nicht höher als ein bestimmter vorher festgesetzter oberer Summenabweichungswert sowie nach unten nicht geringer als ein anderer vorher festgesetzter unterer Summenabweichungswert abweicht, und
wobei bei Blöcken von zweiten Abtastwerten mit einem größeren Abstand zwischen einer Signalleistung in einzelnen Frequenzgruppen und der für den Block von zweiten Abtastwerten berechneten erlaubten Störung die tatsächlich zur Verfügung gestellte Bitzahl größer ist als die tatsächlich zur Verfügung gestellte Bitzahl für einen Block von zweiten Abtastwerten mit einem geringeren Abstand.

20. Codierverfahren nach Anspruch 19,
**dadurch gekennzeichnet, dass** zur Synchronisation von Codierverfahren mit beliebigem Verhältnis von Eingangs- und Ausgangsbittakt, ein "Füllstand" eines mit einem Ausgangsbit-Takt ausgelesenen Puffers als Regelgrösse für eine zu vergebende Bitzahl dient.

21. Codierverfahren nach Anspruch 19 oder 20,
**dadurch gekennzeichnet, dass** von für einen Block von zweiten Abtastwerten zur Verfügung stehenden Bits eine Anzahl der von Zusatzdaten benötigten Bits, die auf dem selben Kanal übertragen werden, abgezogen werden.

22. Codierverfahren nach einem der Ansprüche 19 bis 21,
**dadurch gekennzeichnet, dass** bei Verwendung einer besonderen Bitkombination für ein Synchronwort zur Blocksynchronisation das Synchronwort und alle zufällig mit dem Synchronwort identischen Bitkombinationen mit einem bewusst eingefügten zusätzlichen Bit voneinander unterschieden werden.

23. Codierverfahren nach einem der Ansprüche 11 bis 13,
**dadurch gekennzeichnet, dass** eine äussere Iterationsschleife abgebrochen wird, falls eine innere Schleife innerhalb der maximalen Iterationszahl nicht sicher beendet werden kann.

**24.** Codierverfahren nach einem der Ansprüche 1 bis 23,
**dadurch gekennzeichnet, dass** Bereiche des akustischen Signals, in denen die erlaubte Störung grösser als die Signalenergie ist, gelöscht werden.

**25.** Codierverfahren nach Anspruch 24,
**dadurch gekennzeichnet, dass** eine entstehende Folge von gelöschten Werten durch ein Bit in einer Seiteninformation codiert wird.

**26.** Codierverfahren nach Anspruch 24,
**dadurch gekennzeichnet, dass** eine entstehende Folge von gelöschten Werten durch einen Wert in einer Tabelle von möglichen Quantisierungsstufenhöhen für jede Frequenzgruppe in einer Seiteninformation codiert wird.

**27.** Codierverfahren nach einem der Ansprüche 1 bis 26,
**dadurch gekennzeichnet, dass** die Quantisierung und eine Rekonstruktion so aneinander angepasst sind, dass ein Quantisierungsfehler im Mittel minimal wird.

**28.** Codierverfahren nach Anspruch 27,
**dadurch gekennzeichnet, dass** eine Berechnung der rekonstruierten Werte in einem Empfänger mittels einer Tabelle geschieht, die durch Ermittlung von tatsächlichen Erwartungswerten von Eingangswerten eines Quantisierungsintervalls erstellt wurde.

**29.** Codierverfahren nach Anspruch 27,
**dadurch gekennzeichnet, dass** zur Rekonstruktion mittels einer Quantisierungskennlinie und der Wahrscheinlichkeitsverteilung der Eingangsdaten in einem Decoder für jeden einzelnen quantisierten Wert ein Rekonstruktionswert so berechnet wird, dass der Quantisierungsfehler minimal wird.


**Claims**

**1.** Digital coding method for the transmitting and/or storing of acoustic signals and, particularly, music signals, wherein a sequence of blocks of first sampled values of the acoustic signals is formed,
wherein the sequence of blocks of first sampled values of acoustic signals is transformed into a sequence of blocks of second sampled values on a block-wise basis by means of transform, with the second sampled values of a block being spectral coefficients representing the spectral composition of the first sampled values of the acoustic signal from a corresponding block of the sequence of blocks of the first sampled values,
wherein the sequence of blocks of second sampled values, corresponding to requirements as regards a permissible noise, is quantized at a different accuracy on a block-wise basis and coded, partly or completely, by means of an encoder, and
wherein, an appropriate decoding and a retransform are performed during reproduction,
**characterized in that**
a computation of the permissible noise for quantizing the spectral coefficients of a block of second sampled values being dependent on a permissible noise, which was computed for a block of first sampled values preceding in the sequence of blocks of first sampled values.

**2.** Coding method according to claim 1
**characterized in that** for a computation of the "permissible noise" for a block of first sampled values the signal energy is analysed in various frequency groups, and that the respective values of the block preceding in the sequence of brocks of first sampled values which are corrected by a "forget factor" as well as the values of the actual block of first sampled values are jointly referred to for computing the "permissible noise".

**3.** Coding method according to claim 1 or 2,
**characterized in that** for a computation of the "permissible noise" for a block of first sampled values the energy values of the block preceding in the sequence of blocks of first sampled values are used in a way that low-amplitude spectral coefficients, which follow spectral coefficients of a higher amplitude, are quantized with a reduced precision.

**4.** Coding method according to any of claims 1 to 3
**characterized in that** the computed permissible noise is reduced when a steep energy increase towards high frequencies is detected for the frequency group below the increase.

5. Coding method according to any of claims 1 to 4,
   **characterized in that** an encoder is used, in a manner known per se, in which the probability of occurrence of a quantized spectral coefficient is correlated with a length of a code such that the code word becomes shorter as the frequency of occurrence of the spectral coefficient increases, and
   that a code word as well as possibly an additional code are associated either with several elements of a sequence or with a range of values so as to reduce a size of a table of the encoder.

6. Coding method according to Claim 5,
   **characterized in that** a code word is directly associated with only one part of the value range of a sequence element, and that a joint identifier as well as a special code are assigned to all values outside this sub-range.

7. Coding method according to claim5 or 6,
   **characterized in that** a Huffman code is used as encoder.

8. Coding method according to claim 6 or 7,
   **characterized in that** said special code is a PCM code.

9. Coding method according to any of claims 1 to 8,
   **characterized in that** n spectral coefficients of a block of second sampled values, with n≥2, are combined to form an n-tuple and are jointly coded by the specification of a code word.

10. Coding method according to any of claims 1 to 9,
    **characterized in that** spectral coefficients, particularly of the same number from at least two successive blocks of second sampled values, are combined to form a pair or an n-tuple, respectively, and are jointly coded by the specification of a code word.

11. Coding method according to any of claims 1 to 10, which operates in accordance with the OCF method,
    **characterized in that** a total gain factor is computed, which is transmitted to the receiver as additional information instead of the individual values, by deriving it from the values of the number if iterating steps performed, of the initial value of the quantizing level, the value of the inhomogeneity of the spectrum pattern as well as further level information based on the arithmetic operation.

12. Coding method according to any of claims 11,
    **characterized in that** said additional information about changes of the quantizing level for compliance with the "permissible noise" is jointly formed over more than one block of first sampled values and transmitted.

13. Coding method according to Claim 11 or 12,
    **characterized in that** additional information is coded by means of a code having a variable word length.

14. Coding method according to any of claims 1 to 13,
    **characterized in that** different coding tables are used as a further function of the signal, and that the number of the respective code table used is transmitted or stored, respectively, together with the coded values.

15. Coding method according to claim 14,
    **characterized in that** different coding tables are used for different spectral ranges, and
    that the boundaries between the ranges are invariably predetermined or are determined as a function of the signal.

16. Coding method according to any of claims 1 to 15,
    **characterized in that** one part of said code words of variable length, which represent quantized spectral coefficients of a block of second sampled values, is arranged within a raster pattern, and
    that the remaining code words are distributed into the remaining gaps so as to facilitate the finding of the beginning of a code word without complete decoding or in the event of a fault in transmission.

17. Coding method according to claim 16,
    **characterized in that** an equidistant raster pattern is predetermined for improving the reliability in transmission of messages of different importance in continuous succession, which raster pattern has a length corresponding to the mean length of the messages to be transmitted, and

that the most important message segments are disposed in said raster pattern, and that possibly the position of the less important messages is transmitted in this raster pattern in addition to said most important message segments.

**18.** Coding method according to claims 1 to 17,

**characterized in that** a block start marker and additionally the entropy code length are transmitted for determining the beginning of a next message block in the event of a fault in transmission.

**19.** Digital coding method for the transmitting and/or storing of acoustic signals and, particularly, music signals,

wherein a sequence of blocks of first sampled values of the acoustic signal is formed,

wherein the sequence of blocks of first sampled values of acoustic signal is transformed into a sequence of blocks of second sampled values on a block-wise basis by means of a transform, with the second sampled values of a block being spectral coefficients representing the spectral composition of the first sampled values of the acoustic signal from a corresponding block of the sequence of blocks of the first sampled values,

wherein the sequence of blocks of second sampled values, corresponding to requirements as regards a permissible noise is quantized at a different accuracy on a block-wise basis and coded, partly or completely, by means of an encoder, and

wherein, appropriate decoding and retransform are performed during reproduction,

**characterized in that**

signal segments are used for computing the permissible noise for quantizing of the spectral coefficients of a block of second sampled values, which are longer than the signal segments which are contained in the corresponding block of first sampled values, or

a computation of the permissible noise for quantizing the spectral coefficients of a block of second sampled values being dependent on a permissible noise which was computed for a block of first sampled values preceding in the sequence of blocks of first sampled values, and

wherein it is true for both alternatives that

for coding of one block of second sampled values, a bit number, which is actually made available, may deviate upwards or downwards, as a function of signal properties, a capacity of the transmission channel or for simplifying the coding, from a bit number sum, with the bit number sum being computed such that a constant data rate being maintained for coding the blocks of second sampled values,

wherein a sum of bit numbers being actually made available for coding the blocks of second sampled values, deviates upwards from the bit number sum, not higher than a certain, predetermined upper sum deviation value, as well as downwards, not lower than another, predetermined lower sum deviation value, and

wherein, with blocks of second sampled values with a greater distance between a signal power in individual frequency groups and the permissible noise computed for the block of second sampled values, the bit number, which is actually made available, is greater than the bit number which is actually made available for a block of second sampled values with a smaller distance.

**20.** Coding method according to claim 19,

**characterized in that** a "filling level" of a buffer read at an output bit rate serves as control variable for the bit number to be assigned, so as to synchronize coding methods involving an optional ratio of input bit rate to output bit rate.

**21.** Coding method according to claim 19 to 20,

**characterized in that** a number of the bits required by additional data, which are transmitted on the same channel, is deduced from the number of bits available for one block of second sampled values.

**22.** Coding method according to any of claims 19 to 21,

**characterized in that** when a special bit combination is used for a sync word for block synchronization the sync word and all bit combination accidentally identical with this sync word are discriminated by an intentionally inserted additional bit.

**23.** Coding method according to any of claims 11 to 13,

**characterized in that** an exterior iteration loop is aborted if an interior loop cannot be safely terminated within the maximum number of iterations.

**24.** Coding method according to any of claims 1 to 23,

**characterized in that** spheres of the acoustic signal where the permissible noise exceeds the signal energy are deleted.

**25.** Coding method according to claim 24,
**characterized in that** a resulting sequence of deleted values is coded with a bit in a side information.

**26.** Coding method according to claim 24,
**characterized in that** a resulting succession of deleted values is coded with a value in a table of possible quantization level values for each frequency group in a side information.

**27.** Coding method according to any of claims 1 to 26,
**characterized in that** the quantization and a reconstruction are matched with each other so as to minimize the mean quantization error.

**28.** Coding method according to claim 27,
**characterized in that** reconstructed values are computed in a receiver by means of a table compiled by determining the actual values expected for the initial values expected for the initial values of a quantization interval.

**29.** Coding method according to claim 27,
**characterized in that** for each quantized value the reconstructed value is computed so as to minimize the quantization error, for a reconstruction by means of said quantization characteristic and the probability distribution of the input data in the decoder.

**Revendications**

**1.** Procédé de codage numérique pour la transmission et/ou la mise en mémoire de signaux audio et en particulier de signaux de musique,
dans lequel il est formé une suite de blocs de premières valeurs échantillonnées du signal audio,
dans lequel la suite de blocs des premières valeurs échantillonnées du signal audio est transformée au moyen d'une transformation par blocs en une série de blocs de deuxièmes valeurs échantillonnées, les deuxièmes valeurs échantillonnées d'un bloc étant des coefficients spectraux qui restituent la composition spectrale des premières valeurs échantillonnées du signal audio à partir d'un bloc correspondant de la série de blocs des premières valeurs échantillonnées,
dans lequel la série de blocs des deuxièmes valeurs échantillonnées est quantifiée par blocs avec une précision variable en fonction des exigences à l'égard d'un bruit permis et partiellement ou totalement codée au moyen d'un codeur, et
dans lequel lors de la restitution, il est réalisé un décodage et une transformation inverse correspondante,
**caractérisé en ce que**,
un calcul du bruit permis pour la quantification des coefficients spectraux d'un bloc des deuxièmes valeurs échantillonnées dépend d'un bruit permis qui a été calculé pour un bloc précédent des premières valeurs échantillonnées dans la suite des blocs des premières valeurs échantillonnées.

**2.** Procédé de codage selon la revendication 1,
**caractérisé en ce que**, pour le calcul du bruit permis pour un bloc des premières valeurs échantillonnées, il est procédé à une analyse de l'énergie du signal dans différents groupes de fréquences, et **en ce que** dans chaque cas, les valeurs du bloc précédent dans la suite des blocs des premières valeurs échantillonnées, valeurs qui sont corrigées par un facteur d'oubli, ainsi que les valeurs du bloc actuel des premières valeurs échantillonnées, sont utilisées conjointement pour le calcul du bruit permis.

**3.** Procédé de codage selon la revendication 1 ou 2,
**caractérisé en ce que**, pour le calcul du bruit permis pour un bloc des premières valeurs échantillonnées, on utilise les valeurs d'énergie du bloc précédent dans la suite des blocs des premières valeurs échantillonnées de telle façon que des coefficients spectraux de plus petites amplitudes, qui suivent des valeurs à plus grandes amplitudes, ne seront quantifiés qu'à une précision moindre.

**4.** Procédé de codage selon l'une des revendications 1 à 3, **caractérisé en ce que**, le bruit permis calculé lors de la détection d'une croissance abrupte d'énergie en direction des fréquences élevées, est diminué pour un groupe de fréquences situé au-dessous de cette croissance.

**5.** Procédé selon l'une des revendications 1 à 4,
**caractérisé en ce qu'**il est fait appel à un codeur d'une manière connue en soi, dans lequel la probabilité d'apparition d'un coefficient spectral quantifié est corrélée avec la longueur d'un code de telle façon que le mot code est d'autant plus court que la fréquence de l'apparition du coefficient spectral quantifié est grande, et
**en ce que** pour réduire une taille de tables du codeur, un mot de code ainsi qu'éventuellement un code supplémentaire sont affectés soit à plusieurs éléments d'une série, soit à une gamme de valeurs.

**6.** Procédé de codage selon la revendication 5,
**caractérisé en ce qu'**un mot de code est affecté directement à une partie seulement de la gamme de valeurs d'un élément de la suite et **en ce qu'**un indice d'identification commun ainsi qu'un code particulier sont affectés à toutes les valeurs situées en dehors de cette gamme partielle.

**7.** Procédé de codage selon la revendication 5 ou 6,
**caractérisé en ce que**, en tant que codeur on utilise un code Huffman.

**8.** Procédé de codage selon la revendication 6 ou 7,
**caractérisé en ce que** le code particulier est un code PCM.

**9.** Procédé de codage selon l'une quelconque des revendications 1 à 8,
**caractérisé en ce que** n coefficients spectraux, avec n >/ = 2 sont combinés de façon à former un n-uplet et sont codés ensembles par l'indication d'un mot de code.

**10.** Procédé de codage selon l'une des revendications 1 à 9,
**caractérisé en ce que** des coefficients spectraux, en particulier ayant le même numéro, et provenant d'au moins deux blocs successifs des deuxièmes valeurs échantillonnées sont combinés de façon à former une paire ou respectivement un n-tuple, et sont codés conjointement par l'indication d'un mot de code.

**11.** Procédé de codage selon l'une des revendications 1 à 10, qui fonctionne selon le procédé OCF,
**caractérisé** en qu'à partir des valeurs pour le nombre des pas d'itération réalisés, pour la valeur initiale du pas de quantification, à partir de la valeur pour la variation de l'allure du spectre ainsi que d'autres informations de niveau provenant du déroulement du calcul, il est calculé un facteur d'amplification total qui est transmis au récepteur comme information supplémentaire à la place des valeurs individuelles.

**12.** Procédé de codage selon la revendication 11,
**caractérisé en ce que**, l'information supplémentaire sur les variations d'un pas de quantification pour l'observation du bruit permis est formée en commun sur plus d'un bloc et **en ce qu'**elle est ensuite transmise.

**13.** Procédé selon la revendication 11 ou 12,
**caractérisé en ce que** le codage de l'information supplémentaire s'effectue au moyen d'un code à longueur de mots variable.

**14.** Procédé selon l'une des revendications 1 à 13,
**caractérisé en ce qu'**on utilise des tables de codage différentes en fonction du signal, et **en ce que** conjointement avec les valeurs codées, un numéro de la table de codage utilisée est transmis ou mis en mémoire.

**15.** Procédé de codage selon la revendication 14,
**caractérisé en ce que**, pour différentes gammes spectrales, on utilise des tables de codage différentes, et
**en ce que** les limites entre les gammes sont prédéterminées de façon fixe ou sont déterminées en fonction du signal.

**16.** Procédé de codage selon l'une des revendications 1 à 15,
**caractérisé en ce qu'**une partie des mots codes de longueur variable, qui représentent les coefficients spectraux quantifiés d'un bloc des deuxièmes valeurs échantillonnées, sont disposés dans une trame, et
**en ce que** les mots code restants sont répartis dans les interstices restants de façon qu'en l'absence d'un décodage complet ou dans le cas d'une transmission incorrecte, on puisse trouver plus facilement le début d'un mot code.

**17.** Procédé de codage selon la revendication 16,
**caractérisé en ce que**, pour améliorer la fiabilité de transmission en continu d'informations consécutives d'importances différentes, il est prédéterminé une trame équidistante dont la longueur correspond à la longueur moyenne des informations à transmettre, et
**en ce que** les segments d'information les plus importantes sont ordonnés dans ladite trame et **en ce qu'**éventuellement la position des informations de moindre importance est transmise dans cette trame en plus desdits segments d'information les plus importants.

**18.** Procédé de codage selon l'une des revendications 1 à 17,
**caractérisé en ce que**, pour l'indication du début du bloc d'informations suivant en cas d'erreur de transmission, il est transmis un marquage de début de bloc et de plus une longueur de code d'entropie.

**19.** Procédé de codage pour la transmission et/ou la mise en mémoire de signaux audio et en particulier de signaux de musique,
dans lequel il est formé une série de blocs de premières valeurs échantillonnées du signal audio,
dans lequel la série des blocs des premières valeurs échantillonnées du signal audio sont transformées au moyen d'une transformation par blocs dans une série de blocs de deuxièmes valeurs échantillonnées, les deuxièmes valeurs échantillonnées d'un bloc étant des coefficients spectraux qui restituent la composition spectrale des premières valeurs échantillonnées du signal audio à partir d'un bloc correspondant de la suite des blocs des premières valeurs échantillonnées,
dans lequel la suite des blocs des deuxièmes valeurs échantillonnées est quantifiée avec une précision variable en fonction d'exigences relatives à un bruit autorisé et elle est codée en partie ou complètement, au moyen d'un codeur, et
dans lequel lors de la restitution on effectue un décodage correspondant et une transformation inverse,
**caractérisé en ce que**,
pour un calcul du bruit permis pour la quantification des coefficients_spectraux d'un bloc des deuxièmes valeurs échantillonnées, on utilise des segments de signal plus longs que dans le bloc correspondant de premières valeurs échantillonnées, ou
**en ce qu'**un calcul du bruit permis pour la quantification des coefficients spectraux d'un bloc des deuxièmes valeurs échantillonnées dépend d'un bruit permis qui a été calculé pour un bloc précédent des premières valeurs échantillonnées dans la suite des blocs des premières valeurs échantillonnées, et
en ce valant pour les deux alternatives, que pour le codage d'un bloc des deuxièmes valeurs échantillonnées, un nombre de bits mis effectivement à disposition en fonction des propriétés du signal, de la capacité du canal de transmission ou afin de faciliter le codage, pourra s'écarter vers le haut ou vers le bas d'une somme de nombres de bits, la somme du nombre de bits étant calculée de façon à maintenir un débit constant de données pour le codage des blocs des deuxièmes valeurs échantillonnées,
où une somme de nombres de bits, qui est effectivement mise à disposition pour le codage des blocs des deuxièmes valeurs échantillonnées, ne s'écarte de la somme de nombres binaires vers le haut pas au-delà d'une valeur d'écart de sommes supérieure déterminée, fixée préalablement, ainsi que vers le bas pas moins qu'une autre valeur d'écart de sommes inférieure, fixée préalablement, et
où pour les blocs des deuxièmes valeurs échantillonnées présentant un écart plus important entre une puissance de signal dans les différents groupes de fréquence et le bruit permis calculé pour le bloc des deuxièmes valeurs échantillonnées, le nombre de bits mis effectivement à disposition est supérieur au nombre de bits mis effectivement à disposition pour un bloc des deuxièmes valeurs échantillonnées avec un écart moindre.

**20.** Procédé selon la revendication 19,
**caractérisé en ce que**, pour la synchronisation des procédés de codage ayant un rapport quelconque entre la cadence binaire d'entrée et la cadence binaire de sortie, un tampon lu à une cadence binaire de sortie sert de variable de régulation pour le nombre de bits à affecter.

**21.** Procédé de codage selon la revendication 19 ou 20,
**caractérisé en ce qu'**un nombre de bits nécessaires pour les données supplémentaires qui sont transmises sur le même canal, est soustrait du nombre de bits disponible pour un bloc de deuxième valeurs échantillonnées.

**22.** Procédé selon l'une des revendications 19 à 21,
**caractérisé en ce que**, dans le cas de l'utilisation d'une combinaison particulière de bits pour un mot de synchronisation destiné à la synchronisation du bloc, le mot de synchronisation et toutes les combinaisons de bits éventuellement identiques au mot de synchronisation sont discriminées par un bit supplémentaire qui est volontairement inséré.

**23.** Procédé selon l'une des revendications 11 à 13,
**caractérisé en ce qu'**une boucle d'itération extérieure est interrompue si une boucle intérieure ne peut pas être finie de façon sûre avant la fin du nombre maximal d'itérations.

**24.** Procédé de codage selon l'une des revendications 1 à 23,
**caractérisé en ce qu'**on efface les domaines du signal audio dans lesquels le bruit permis est supérieur à l'énergie du signal.

**25.** Procédé de codage selon la revendication 24,
**caractérisé en ce qu'**une suite résultante des valeurs effacées est codée par un bit dans une information auxiliaire.

**26.** Procédé de codage selon la revendication 24,
**caractérisé en ce qu'**une suite résultante de valeurs effacées est codée par une valeur dans la table des valeurs possibles des pas de quantification pour chaque groupe de fréquence dans une information auxiliaire.

**27.** Procédé de codage selon l'une des revendications 1 à 26,
**caractérisé en ce que** la quantification et une restitution sont adaptées l'une à l'autre de façon à minimiser en moyenne l'erreur de quantification.

**28.** Procédé de codage selon la revendication 27,
**caractérisé en ce qu'**il est procédé à un calcul des valeurs reconstituées dans un récepteur au moyen d'une table qui est établie par la détermination des valeurs actuelles attendues pour les valeurs d'entrée d'un intervalle de quantification.

**29.** Procédé de codage selon la revendication 27,
**caractérisé en ce que** pour la restitution au moyen d'une caractéristique de quantification et de la répartition de probabilités des données d'entrées dans un décodeur pour chaque valeur individuelle quantifiée, on calcule une valeur de restitution telle que l'erreur de quantification est minimale.

| x |    | Lx |   Betrag der quantisierten Werte,
         f     Frequenz

FIG. 1

Gesamtlänge des zu einer Nachricht gehörenden Entropiecodes N

Synchronstellen

1. Wort

1. Rest

größtmögliche Einzelwortlänge = Synchronisationsrahmen

1. bis N/Z, Wort der Nachricht, beginnend jeweils nach der Länge des längstmöglichen Wortes

Pro Synchronisationsrahmen verbleibender Rest der nach Vergabe der Plätze mit definiertem Beginn mit den noch übrigen Bit aufgefüllt wird

"Überstehende" Bit, die im 1. Rest angeordnet werden

FIG. 2

1. Nachricht  2. Nachricht  3. Nachricht  4. Nachricht  5. Nachricht  6. Nachricht

1. Nachricht  2. Nachricht  3. Nachricht  4. Nachricht  5. Nachricht

◻️ Besonders zu schützender
Nachrichtenteil

FIG. 3

Auslesepointer

M−        M+

Eingabepointer falls              Eingabepointer    falls Bitsparkasse
Bitsparkasse leer                 voll

Reserve
für Regelung

M−, M+ : Marken für die Differenz
von Eingabe- und Auslesepointer bei
deren Überschreiten die Regelung für
die zu vergebende Bitzahl einsetzt

Ringpuffer

FIG. 4

|Aspek|  Betrag der Spektralwerte
f        Häufigkeit

|Aspek|

Quantisierungsintervall für "1"

FIG. 5

23